(19) Europäisches Patentamt
European Patent Office
Office européen des brevets

(11) **EP 4 290 775 B1**

(12) **EUROPEAN PATENT SPECIFICATION**

(45) Date of publication and mention
of the grant of the patent:
**21.01.2026   Bulletin 2026/04**

(21) Application number: **22778332.1**

(22) Date of filing: **24.01.2022**

(51) International Patent Classification (IPC):
*H03M 7/30* (2006.01)   *G06F 3/06* (2006.01)

(52) Cooperative Patent Classification (CPC):
**H03M 7/3064; G06F 3/0608; G06F 3/0641;**
**H03M 7/3071;** H03M 7/6029; H03M 7/6064

(86) International application number:
**PCT/CN2022/073432**

(87) International publication number:
**WO 2022/206144 (06.10.2022 Gazette 2022/40)**

(54) **DATA COMPRESSION METHOD AND APPARATUS**

VERFAHREN UND VORRICHTUNG ZUR DATENKOMPRIMIERUNG

PROCÉDÉ ET APPAREIL DE COMPRESSION DE DONNÉES

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.03.2021   CN 202110343760**

(43) Date of publication of application:
**13.12.2023   Bulletin 2023/50**

(73) Proprietor: **Huawei Technologies Co., Ltd.**
**Shenzhen, Guangdong 518129 (CN)**

(72) Inventors:
• **WU, Jinkang**
**Shenzhen, Guangdong 518129 (CN)**
• **TU, Jianhong**
**Shenzhen, Guangdong 518129 (CN)**

• **SHEN, Jianqiang**
**Shenzhen, Guangdong 518129 (CN)**
• **QUAN, Shaohui**
**Shenzhen, Guangdong 518129 (CN)**

(74) Representative: **Gill Jennings & Every LLP**
**The Broadgate Tower**
**20 Primrose Street**
**London EC2A 2ES (GB)**

(56) References cited:
EP-A1- 2 940 598        EP-A1- 3 820 048
WO-A1-2020/025006        CN-A- 110 784 225
CN-A- 110 879 800        CN-A- 110 888 851
CN-A- 111 683 046        US-A1- 2006 291 505
US-B1- 10 310 737

**Description**

This application claims priority to Chinese Patent Application No. 202110343760.2, filed with the China National Intellectual Property Administration on March 30, 2021 and entitled "DATA COMPRESSION METHOD AND APPARATUS".

**TECHNICAL FIELD**

This application relates to the data storage field, and in particular, to a data compression method and apparatus.

**BACKGROUND**

With advent of the information age, a large amount of data has been produced. In many fields, data needs to be compressed according to compression algorithms. There may be different mechanisms of compression algorithms such as duplicate content search, entropy encoding, and the like. The duplicate content search mechanism-based compression algorithms include a Lempel-Ziv (Lempel-Ziv, LZ) encoding algorithm, a run-length encoding (run-length encoding, RLE) algorithm, and the like. The entropy encoding mechanism-based compression algorithms include a Huffman encoding algorithm, an arithmetic encoding algorithm, and the like.

Currently, during data compression, one compression algorithm is usually used to compress all to-be-compressed data, and a length of compressed data is unknown before compression. However, many applications such as a mail application and a database application have a length limit for to-be-processed data. Data that does not meet the length limit cannot be processed. For example, for the email application, a transmission error will occur if a length of data exceeds the limit.

EP3820048A1 discloses a data compression method, a data decompression method, and a related apparatus, an electronic device, and a system. In the data compression method, a raw data block in raw data is processed based on a compression algorithm to obtain a standard compressed data block that has a length of L2 and that corresponds to the raw data block, and the raw data is further compressed into one or more standard compressed data blocks that each have the length of L2 and that are to be decompressed in parallel by a decompression apparatus, where the decompression apparatus includes a plurality of decompression engines, and each decompression engine is capable of decompressing one standard compressed data block within one processing cycle. According to the data compression method disclosed in this document, a standard compressed data block with a fixed length can be obtained through compression. In this way, various decompression engines can synchronously decompress a plurality of standard compressed data blocks. This improves data decompression efficiency.

US10310737B1 discusses the following: solid-state storage devices may be employed to store data maintained by a database management system, but may have characteristics that reduce the efficiency of interactions between the database management system and the device. A storage subsystem may receive information indicative of internal boundaries within database data. A segment of the database data may be selected for compression, wherein the size of the segment is based at least on one or more the internal boundaries, the memory page size of the solid-state drive, and a predicted rate of compression. The compressed segment may be stored if it has a size less than the memory page size of the device. If it does not, compression may be retried with a smaller segment of data or a portion of the data may be stored in uncompressed form. Additional segments of the data may be stored on the solid-state drive in a similar manner.

WO2020025006A1 discloses a data compression and decompression method and a related apparatus, electronic device, and system, the data compression method processing original data blocks in original data on the basis of a compression algorithm to obtain standard compressed data blocks of length L2 corresponding to the original data blocks, and then compressing the original data into one or a plurality of standard compressed data blocks of length L2 for parallel decompression by a decompression apparatus, the decompression apparatus comprising a plurality of decompression engines, each decompression engine being capable of decompressing one standard compressed data block in one processing period. Executing the data compression method disclosed in this document can compress into standard compressed data blocks of a fixed length, such that the decompression engines can perform synchronous decompression when decompressing the plurality of standard compressed data blocks, increasing data decompression efficiency.

**SUMMARY**

This application provides a data compression method. According to the method, when a length of to-be-compressed data after compression is greater than a length limit value, compressed data is segmented based on the length limit value during compression, so that the compressed data includes a plurality of pieces of sub compressed data, and a length of the sub compressed data is less than the limit value, so that the data can be processed by applications, and application requirements are met. This application further provides an apparatus, a computer-readable storage medium, and a computer program product corresponding to the foregoing method.

According to a first aspect, this application provides a data compression method as set out in appended claim 1. The method may be performed by a computer device. The computer device may be a terminal or a server. For ease of description, an example in which the computer device is a terminal is used for description.

Specifically, the terminal obtains to-be-compressed data and a length limit value for data compression. When a length of data obtained by compressing the to-be-compressed data is greater than the length limit value, the terminal segments the to-be-compressed data based on the length limit value in a process of compressing the to-be-compressed data, so that the to-be-compressed data includes at least two compressed files after compression, and a length of each compressed file is less than the length limit value.

Even if the length of the data obtained by compressing the to-be-compressed data is greater than the limit value, according to the method, the compressed data can be segmented into a plurality of compressed files whose lengths are less than or equal to the length limit value, so that the data can be successfully processed by applications, and application requirements are met.

The terminal predicts a length of each compressed data block one by one, and accumulate lengths of a currently predicted data block and data blocks before the currently predicted block to obtain a first predicted compression length. When the first predicted compression length is greater than the length limit value, the terminal may perform compression based on the data blocks before the currently predicted data block, where compressed data forms a first compressed file, and the first compressed file belongs to the at least two compressed files.

A time consumed for predicting the compressed lengths of the data blocks is much less than a time consumed for compressing the data blocks and then determining the compressed lengths. Therefore, the compressed lengths are predicted first, then the to-be-compressed data is segmented based on prediction results, and compression is performed based on segmented data, thereby effectively improving compression efficiency.

In some possible implementations, there are N data blocks before the currently predicted data block. Therefore, when the first predicted compression length obtained by accumulating the lengths of the currently predicted data block and the data blocks before the currently predicted data block is greater than the length limit value, the terminal may roll back a data block, and perform merging and compression on some or all data blocks (for example, first to $(N - k)^{th}$ data blocks, where N is a natural number greater than or equal to 2, and k is a natural number less than N) of the N data blocks before the currently predicted data block. When a length of the compressed data is less than or equal to the length limit value, the compressed data is used as the first compressed file.

By performing data block rollback when the first predicted compression length is greater than the length limit value, a quantity of compression times can be effectively reduced, thereby improving the compression efficiency.

In some possible implementations, when a length of data obtained by merging and compressing the first to $(N - k)^{th}$ data blocks is less than or equal to the length limit value, the terminal may continue to predict a compressed length of a data block after the $(N - k)^{th}$ data block, to continue to segment remaining data of the to-be-compressed data. In this way, repeated compression can be avoided, a computing amount is reduced, and computing resource overheads are reduced.

In some possible implementations, there are N data blocks before the currently predicted data block, and the terminal performs compression based on the data blocks before the currently predicted data block. Specifically, the terminal may first perform merging and compression on the first to $(N - k)^{th}$ data blocks, where N is a natural number greater than or equal to 2, and k is a natural number less than N. When the length of the compressed data is greater than the length limit value, the terminal may roll back a data block and perform merging and compression on data blocks after rollback. For example, the terminal may perform merging and compression on first to $(N - k - 1)^{th}$ data blocks.

Through step-by-step rollback, the quantity of compression times can be reduced, the compression efficiency is improved, and compression overheads are reduced.

In some possible implementations, the to-be-compressed data may be a data stream that is not divided into blocks. The terminal performs block division on the data stream to obtain a plurality of data blocks. When a segmentation position of data does not affect the data, the terminal further performs block division based on the following block division method, to ensure that a reduction rate is improved while lengths of all compressed files formed by merging and compressing the data blocks do not exceed the limited length.

Specifically, the terminal first performs block division on the to-be-compressed data for a first time, for example, performs block division according to an average block division method, to obtain a plurality of initial data blocks. The terminal may record boundary values of the plurality of initial data blocks, and the boundary value may be represented by a sequence number of a last byte of the initial data block.

The terminal further performs matching on the plurality of initial data blocks. For example, the terminal may perform matching according to an LZ encoding algorithm, to obtain a four-tuple of each initial data block. The four-tuple includes inter-block four-tuples, which is specifically a four-tuple generated when different data blocks are successfully matched. When one data block is successfully matched with a plurality of data blocks, the terminal records a four-tuple generated when the data block is matched with a data block closest to the data block. The four-tuple includes an unmatched character sequence, an unmatched character length, a match length, and a match offset. A matched character sequence and a match character sequence may form a match.

The terminal may determine, based on a boundary of the initial data block and a four-tuple (for example, a match offset in the four-tuple) of the initial data block, whether the boundary and the match intersect. If a character representing the boundary is between the matched character sequence and the match character sequence, the boundary and the match intersect. Based on this, the terminal may take statistics of quantities of intersections of boundaries of the initial data blocks and matches. The terminal may select an optimal position for block division based on the quantities of intersections. For example, the terminal may select a boundary having a minimum quantity of intersections with the match or a boundary less than a preset value as the optimal position for block division. The terminal merges, based on the optimal positions for block division, data blocks between the optimal positions for block division, to obtain final data blocks.

When the compression algorithm requires rollback by block division, the rollback is performed based on the optimal position for block division. In this case, data on two sides of the optimal position for block division separately participates in compression. Because a quantity of matches of inputted data that needs to cross the position is small, and lengths of the matches are short, when compression is performed in this block division manner, a loss of an overall compression ratio is smaller compared to that before block division.

According to a second aspect, this application provides a data compression apparatus according to appended claim 5.

According to a third aspect, this application provides a computer-readable storage medium. The computer-readable storage medium stores instructions, and the instructions instruct a device to perform the data compression method according to the first aspect or any implementation of the first aspect.

According to a fourth aspect, this application provides a computer program product including instructions. When the computer program product is run on a device, the device is enabled to perform the data compression method according to the first aspect or any implementation of the first aspect.

In this application, the implementations according to the foregoing aspects may be further combined to provide more implementations.

## BRIEF DESCRIPTION OF DRAWINGS

To describe the technical method in embodiments of this application more clearly, the following briefly describes the accompanying drawings used for the embodiments.

FIG. 1 is a schematic diagram of a structure of a terminal according to an embodiment of this application;
FIG. 2 is a flowchart of a data compression method according to an embodiment of this application;
FIG. 3 is a schematic diagram of a graphical user interface according to an embodiment of this application;
FIG. 4 is a schematic diagram of block division of data according to an embodiment of this application;
FIG. 5 is a schematic flowchart of a data compression method according to an embodiment of this application;
FIG. 6 is a schematic flowchart of a data compression method according to an embodiment of this application; and
FIG. 7 is a schematic diagram of a structure of a data compression apparatus according to an embodiment of this application.

## DESCRIPTION OF EMBODIMENTS

In embodiments of this application, the terms "first" and "second" are used merely for the purpose of description, and shall not be construed as indicating or implying relative importance or implying a quantity of indicated technical features. Therefore, features defining "first" and "second" may explicitly or implicitly include one or more such features.

First, some technical terms used in embodiments of this application are described.

Data compression: Data compression is a process of representing information with data bits (or other information-related units) fewer than those without encoding based on a specific encoding mechanism. Data compression is specifically implemented according to data compression algorithms. According to different encoding mechanisms, the data compression algorithms may be classified into different types such as compression algorithms based on a duplicate content search mechanism and compression algorithms based on an entropy encoding mechanism. The compression algorithms based on the duplicate content search mechanism include an LZ encoding algorithm, an RLE algorithm, and the like. The LZ encoding algorithm is used as an example. A compression principle of the LZ encoding algorithm is to traverse inputted data to generate a historical dictionary, and a repeated piece of data is stored in a form of a dictionary index that occupies less space. The compression algorithms based on the entropy encoding mechanism include a Huffman encoding algorithm, an arithmetic encoding algorithm, and the like. The Huffman encoding algorithm is used as an example. A compression principle of the Huffman encoding algorithm is to re-encode characters based on a fact that different characters have different occurrence frequencies in the inputted data to implement compression.

Currently, during data compression, a compression algorithm is usually used to compress all to-be-compressed data, and a length of compressed data is unknown before compression. However, many applications, such as a mail application and a database application, have a length limit for to-be-processed data. Data that does not meet the length limit cannot be processed. For example, for the email application, a transmission error occurs if a length of data exceeds the limit. Based on this, the industry urgently needs to provide a data compression method, to limit the length of the compressed data, so as to meet application requirements.

An embodiment of this application provides a data compression method. Before data compression, a length limit value of data of an application processing the data is first obtained. When a length of data obtained by compressing to-be-compressed data is greater than the length limit value, compressed data is segmented based on the length limit value in a process of data compression, so that the compressed data includes at least two pieces of sub compressed data, and a length of the sub compressed data is less than the limit value. In this way, even if the length of the data obtained by compressing the to-be-compressed data is greater than the limit value, the data can be successfully processed by the application.

This embodiment of this application may be applied to different application scenarios. For example, this embodiment may be applied to an email application. The email application has a limit on a size of an email attachment. Assuming that a size of an attachment allowed to be uploaded in the email application is within 20 megabytes (megabyte, MB), an attachment with a size greater than 20 MB may be compressed, and a plurality of compressed files with sizes less than 20 MB are obtained. For another example, this embodiment may be applied to an information management system. The information management system has a limit on a size of an attachment uploaded by a user. In this case, the attachment may be compressed, and the attachment is compressed into a plurality of compressed files with sizes less than the length limit value.

The mail application and the information management system are merely examples for describing an application scenario. The data compression method may further be applied to another scenario in which a compressed length is limited. For example, the method may be applied to a scenario in which a bottleneck occurs in a transmission bandwidth and transmission reliability, or applied to a scenario in which a compressed length is limited due to a storage granularity or a network transmission requirement during video compression or the like.

The data compression method provided in this embodiment of this application may be performed by a computer device. The computer device may be a terminal or a server. The terminal includes but is not limited to a device such as a desktop computer, a notebook computer, a tablet computer, or a smartphone. The server may be a local server (such as a server in a privately owned data center) or a cloud server (such as a server in a data center of a cloud service provider). Further, the method may be performed by a single computer device, or may be performed by a cluster formed by a plurality of computer devices, and stability and reliability of a data compression service can be improved when the method is performed by the cluster.

For ease of understanding, the following uses an example in which a terminal performs the data compression method for description.

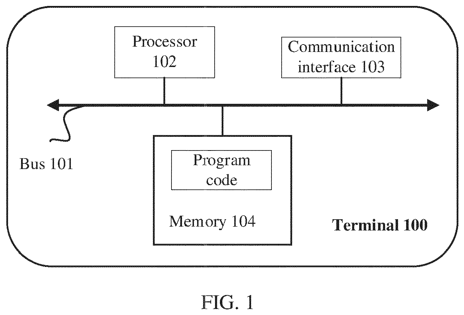

First, a hardware structure of the terminal is described. FIG. 1 is a schematic diagram of a structure of a terminal according to an embodiment of this application. As shown in FIG. 1, a terminal 100 includes a bus 101, a processor 102, a communication interface 103, and a memory 104. The processor 102, the memory 104, and the communication interface 103 communicate with each other through the bus 101.

The bus 101 may be a peripheral component interconnect (peripheral component interconnect, PCI) bus, an extended industry standard architecture (extended industry standard architecture, EISA) bus, or the like. The bus may be classified into an address bus, a data bus, a control bus, or the like. For ease of description, the bus in FIG. 13 is represented by using only one bold line, but which does not indicate that there is only one bus or one type of bus.

The processor 102 may be any one or more of processors such as a central processing unit (central processing unit, CPU), a graphics processing unit (graphics processing unit, GPU), a microprocessor (microprocessor, MP), or a digital signal processor (digital signal processor, DSP).

The communication interface 103 is configured to communicate with the outside. For example, the communication interface 103 is configured to obtain to-be-compressed data, obtain a length limit value for data compression, or output at least two compressed files whose lengths are less than the length limit value, or the like.

The memory 104 may include a volatile memory (volatile memory), for example, a random access memory (random access memory, RAM). The memory 104 may further include a non-volatile memory (non-volatile memory), for example, a read-only memory (read-only memory, ROM), a flash memory, a hard disk drive (hard disk drive, HDD), or a solid-state drive (solid-state drive, SSD).

The memory 104 stores executable code, and the processor 102 executes the executable code to perform the foregoing data compression method.

FIG. 1 describes in detail a hardware structure of the terminal 100 configured to perform the data compression method. The following describes in detail the data compression method provided in this embodiment of this application from a perspective of the terminal 100 with reference to the accompanying drawings.

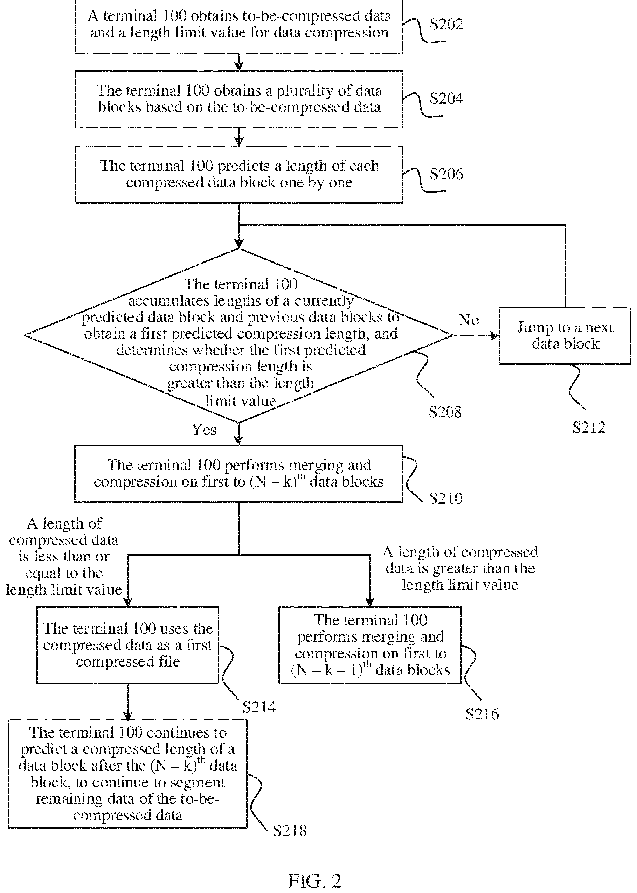

Refer to a flowchart of the data compression method shown in FIG. 2, the method includes:
S202: The terminal 100 obtains to-be-compressed data and a length limit value for data compression.

Specifically, the terminal 100 may provide a user interface. The user interface may be a graphical user interface (graphical user interface, GUI) or a command user interface (command user interface, CUI). The terminal 100 may receive data inputted by a user through the GUI or the CUI and the length limit value for data compression. The length limit value for data compression is a limit value for a length of the to-be-compressed data after being compressed by an application processing the to-be-compressed data. The terminal 100 may directly receive the data inputted by the user, or may receive a storage path of the data inputted by the user, and then obtain the data according to the storage path.

The following uses the GUI as an example to describe how the terminal obtains the to-be-compressed data and the length limit value for data compression.

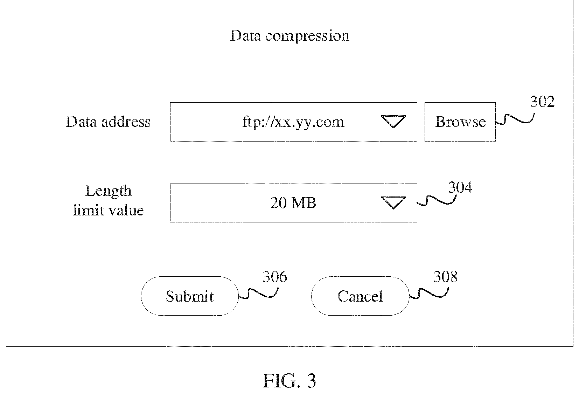

Refer to a schematic interface diagram of the GUI shown in FIG. 3, as shown in FIG. 3, the GUI bears a storage address input control 302 and a length limit value input control 304. The storage address input control 302 is configured to input a storage address of data, and the storage address input control 302 supports a drop-down input manner. The length limit value input control 304 is configured to input a length limit value. The GUI further bears a submit control 306 and a cancel control 308. After inputting the storage address of the data through the storage address input control 302 and inputting the length limit value through the length limit value input control 304, the user may click the submit control 306 to trigger a submission operation. The terminal 100 may obtain the data and the length limit value in response to the submission operation of the user.

It should be noted that, in some embodiments, an application may alternatively set a length limit value by default. In this way, the GUI may not bear the foregoing length limit value input control 304, the user does not need to configure the length limit value, but inputs a storage address of the to-be-compressed data through the GUI. The terminal 100 obtains the to-be-compressed data according to the storage address and obtains the length limit value according to a default setting.

S204: The terminal 100 obtains a plurality of data blocks based on the to-be-compressed data.

The data includes a plurality of data blocks. The plurality of data blocks included in the data are obtained by the terminal 100 by performing block division on the data. For example, the terminal 100 may perform average block division on the data based on a quantity of the data blocks or a length of a data block, to obtain the plurality of data blocks. It should be noted that, when a total length of the data cannot be exactly divided by the quantity of the data blocks or the length of a data block, a length of a specific data block may not be equal to a length of the other data blocks. For example, when the length of the data is 130 KB and the length of a single data block is 8 KB, the data may be divided into 15 data blocks of 8 KB and a data block of 10 KB.

For a scenario in which the data is not explicitly divided into blocks, for example, the inputted data is a consecutive input with a long length, and a segmentation position of the data does not affect the data, this embodiment of this application may further provide a block division method, to improve a reduction rate while all compressed files formed by merging and compressing the data blocks do not exceed a specified length.

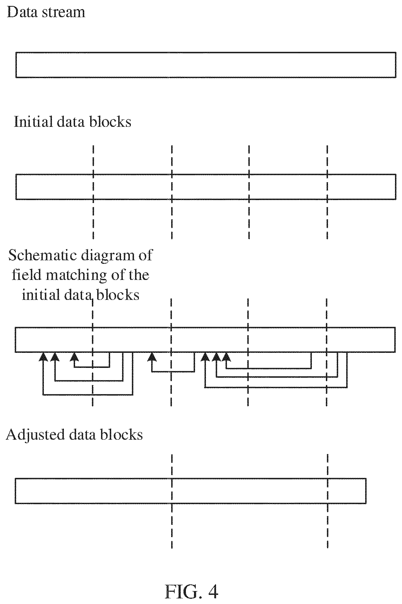

Refer to a schematic flowchart of block division of data shown in FIG. 4, original data is a consecutive data stream, and the terminal 100 may divide the data into a plurality of initial data blocks with an equal size in an average block division manner. The terminal 100 may record boundary values of the plurality of initial data blocks, and the boundary value may be represented by a sequence number of a last byte of the initial data block. Subsequently, the terminal 100 may further perform matching on the plurality of initial data blocks. For example, the terminal 100 may perform matching according to an LZ encoding algorithm, to obtain a four-tuple of each initial data block. The four-tuple includes inter-block four-tuples, which is specifically a four-tuple generated when different data blocks are successfully matched. When one data block is successfully matched with a plurality of data blocks, in this embodiment of this application, a four-tuple generated when the data block is matched with a data block closest to the data block is recorded. The four-tuple includes an unmatched character sequence, an unmatched character length, a match length, and a match offset.

For ease of understanding, this application provides a specific example. In this example, it is assumed that a length of the data stream is 500 bytes (byte, B). The terminal 100 performs block division based on an average block division method to obtain a plurality of initial data blocks, and boundaries of the initial data blocks are positions 100B, 200B, ..., 400B, and the like. The data stream and the boundaries of the initial data blocks are specifically as follows: (......QWER......XYZ......TYUI......, (100B), ......QWER......TYUI......XYZ......, (200B), ......LMN......TYUI......OPQ......SDF......, (300B), ......LMN......, (400B), ......SDF......OPQ......)

The ellipsis represents a character that fails to be matched, "QWER" and the like represent characters that are successfully matched, and (100B), (200B), and the like represent the boundaries of the initial data blocks. "QWER" in a first data block is successfully matched with "QWER" in a second data block, "XYZ" in the first data block is successfully matched with "XYZ" in the second data block, "TYUI" in the first data block is successfully matched with "TYUI" in the second data block, "TYUI" in the second data block is successfully matched "TYUI" in a third data block, "LMN" in the third data block is successfully matched with "LMN" in a fourth data block, "OPQ" in the third data block is successfully matched with "OPQ" in a fifth data block, and "SDF" in the third data block is successfully matched with "SDF" in the fifth data block.

The terminal 100 may record, based on the foregoing matching results, quantities of intersections of the boundaries and matches. That a boundary and a match intersect means that a boundary character is between the match characters. Based on this, in the foregoing example, the terminal 100 may determine that a quantity of intersections of the boundary 100B and matches is 3, a quantity of intersections of the boundary 200B and a match is 1, a quantity of intersections of the boundary 300B and matches is 3, and a quantity of intersections of the boundary 400B and matches is 2. The terminal 100 may select an optimal position for block division based on the quantities of intersections of the boundaries and the matches, and merges the initial data blocks based on the optimal position for block division to obtain final data blocks. The terminal 100 may select a boundary having a minimum quantity of intersections with the match or a boundary less than a preset value as the optimal position for block division. For example, the terminal 100 may select 200B as the optimal position for block division. Further, the terminal 100 may alternatively select 400B as the optimal position for block division.

When the compression algorithm requires rollback by block division, the rollback is performed based on the optimal position for block division. In this case, data on two sides of the optimal position for block division separately participates in compression. Because a quantity of matches of inputted data that needs to cross the position is smallest, and lengths of the matches are shortest, when compression is performed in this block division manner, a loss of an overall compression ratio is smaller compared to that before block division.

S206: The terminal 100 predicts a length of each compressed data block one by one.

In some possible implementations, when a compression algorithm based on an entropy encoding mechanism is used for the data blocks, the terminal 100 may predict a predicted value of the compressed length of each data block one by one based on a Shannon-Fano entropy limit. Specifically, the Shannon-Fano entropy limit is calculated according to the following formula:

$$H(x) = -\sum_x p(x) \log_2 p(x) \quad (1),$$

where

x indicates a character inputted through entropy encoding, $p(x)$ indicates an occurrence probability of the character x, H(x) indicates the Shannon-Fano entropy limit that is specifically a minimum quantity of bits (bit) of per inputted byte after entropy encoding. Based on this, the predicted value of the compressed length of the data block can be determined based on an entropy encoding input length (for example, a quantity of bytes) and the Shannon-Fano entropy limit, which is specifically shown as follows:

$$len_{out}x = len_{in} * H(x) = len_{in} * (-\sum_x p(x) \log_2 p(x)) \quad (2),$$

where

$len_{in}$ indicates an input length, for example, a quantity of bytes of an entropy encoding input, and $len_{out}x$ indicates an output length, for example, a predicted value of a length obtained after entropy encoding is performed on an input. It should be noted that, when the terminal 100 directly performs entropy encoding on a data block, the input length may be a length of the data block.

The terminal 100 first performs matching on the data blocks, for example, perform matching on the data blocks one by one according to an LZ encoding algorithm, to obtain a four-tuple of each data block, and the four-tuple includes an inter-block four-tuple and an intra-block four-tuple. For the inter-block four-tuple, refer to the foregoing related content descriptions. The intra-block four-tuple refers to a four-tuple generated when matching in the data block succeeds. Similar to the inter-block four-tuple, the intra-block four-tuple also includes an unmatched character sequence, an unmatched character length, a match length, and a match offset. The terminal 100 may use the four-tuple as an entropy encoding input to perform entropy encoding, to implement compression on the data block. Correspondingly, the input length may be a length of the four-tuple. The terminal 100 may determine, based on the length of the four-tuple and the Shannon-Fano entropy limit, the predicted value of the length obtained after entropy encoding is performed on the input.

The terminal 100 may separately perform character frequency statistics based on each element (such as the unmatched character sequence, the unmatched character length, the match length, and the match offset) of the four-tuple, that is, a quantity of occurrences of each type of character in each element is counted, and the occurrence probability $p(x)$ of the character x is obtained by dividing the character frequency by a total quantity of the characters. In this way, the terminal 100 may use $p(x)$ to determine the Shannon-Fano entropy limit H(x) according to the foregoing formula (1).

In some possible implementations, the terminal 100 may further manage process data generated in a prediction process. The process data may include the four-tuples generated when matching is performed on the data blocks, and boundary information corresponding to the four-tuples of the data blocks. The terminal 100 may store the four-tuples of the data blocks and the boundary information of the four-tuples. The boundary information includes quantities of the four-tuples of the data blocks. For example, the terminal 100 performs matching on a data block and obtains 10 four-tuples. The terminal 100 may store the 10 four-tuples corresponding to the data block and store a quantity (for example, 10) of the four-tuples corresponding to the data block. In this way, the terminal 100 may distinguish four-tuples of different data blocks according to the boundary information, and may further quickly obtain a corresponding four-tuple, to implement a fast data block rollback.

In some other possible implementations, the terminal 100 may further obtain a historical compression rate, and the historical compression rate includes a compression rate of data compression by the terminal 100 before current compression. The compression rate of data compression includes an overall compression rate, and the overall compression rate may provide a reference for a compression rate of the data block. Based on this, the terminal 100 may predict a compressed length of a data block based on a length of the data block and the historical compression rate. For example, the terminal 100 may determine a product of the length of the data block and the historical compression rate as the predicted value of the compressed length of the data block. In some embodiments, the terminal 100 may determine an average value of the historical compression rate, for example, determine an average value of overall compression rates in five latest times, and then determine the predicted value of the compressed length of the data block based on the length of the data block and the average value of the historical compression rate.

Further, the terminal 100 may update the historical compression rate, so that the historical compression rate can be close to an actual compression rate, thereby implementing accurate prediction of the compressed length. Specifically, the terminal 100 may determine a current compression rate based on the length of the data and a length of compressed data of the data, and then update the historical compression rate based on the current compression rate. The updated historical compression rate can be used for a next round of prediction. When managing the historical compression rate, the terminal 100 may adopt a first in first output (first in first output, FIFO) policy or the like for management.

S208: The terminal 100 accumulates lengths of a currently predicted data block and data blocks before the currently predicted data block to obtain a first predicted compression length, and determines whether the first predicted compression length is greater than the length limit value. When the first predicted compression length is greater than the length limit value, S210 is performed. When the first predicted compression length is less than or equal to the length limit value, S212 is performed.

It is assumed that there are N data blocks before the currently predicted data block. The terminal 100 accumulates predicted compression lengths of the N data blocks and a predicted compression length of the current data block, to obtain the first predicted compression length. When the first predicted compression length is greater than the length limit value, it indicates a high probability that compressed lengths of the N + 1 data blocks are greater than the length limit value, and the terminal 100 may perform data block rollback, for example, one data block is rolled back. In this case, a probability of obtaining a compressed file whose compressed length is less than or equal to the length limit value is high. Based on this, the terminal may perform S210. When the first predicted compression length is less than or equal to the length limit value, it indicates a high probability that the compressed lengths of the N + 1 data blocks are less than the length limit value, and the terminal 100 may still add a new data block for being merged and compressed, thereby improving an input granularity as much as possible. Based on this, the terminal 100 may perform S212.

S210: The terminal 100 performs merging and compression on first to (N - k)$^{th}$ data blocks. When a length of compressed data is less than or equal to the length limit value, S214 is performed. When the length of the compressed data is greater than the length limit value, S216 is performed.

N is a natural number greater than or equal to 2, and k is a natural number less than N. For example, a value of k may be 0, 1, or the like. The terminal 100 may merge some or all data blocks of the N data blocks before the currently predicted data block. For example, the terminal 100 may merge the N data blocks, and then implement compression on a merged data block. The terminal 100 may select a corresponding compression algorithm according to an actual requirement, to implement compression on the merged data block. For example, the terminal 100 may select a compression algorithm based on entropy encoding, for example, a Huffman encoding algorithm or an arithmetic encoding algorithm, or select a compression algorithm based on duplicate content search, for example, an LZ encoding algorithm or an RLE algorithm, to implement compression on the merged data block.

When the terminal 100 determines the four-tuples of the data blocks according to the LZ encoding algorithm and predicts the compressed lengths based on the four-tuples of the data blocks, the terminal 100 may use the foregoing four-tuples to perform entropy encoding according to the LZ encoding algorithm, to implement compression on the merged data block. When the terminal 100 predicts the compressed lengths of the data blocks based on the historical compression rate, the terminal 100 may select the compression algorithm based on entropy encoding or the compression algorithm based on duplicate content search (for example, the LZ encoding algorithm) for encoding, to implement compression on the merged data block.

S212: The terminal 100 jumps to a next data block, uses the next data block as the currently predicted data block, and performs S208.

Specifically, the terminal 100 gradually accumulates predicted compression lengths of new data blocks. When a sum of the predicted compression lengths of the data blocks is less than or equal to the length limit value, the terminal 100 jumps to a next data block, and continues to accumulate. When the sum of the lengths is greater than the length limit value, the terminal 100 may stop accumulating. In this way, the terminal 100 may determine proper segmentation points in these data blocks, to segment a plurality of data blocks, and further perform merging and compression on the segmented data blocks.

S214: The terminal 100 uses the compressed data as a first compressed file and then performs S218.

The length of the compressed data is less than or equal to the length limit value, and a small quantity of data blocks are rolled back to be compressed in a case that the predicted compression length is greater than the length limit value. Therefore, the length of the compressed data is close to the length limit value, and the terminal 100 may use the compressed data as the first compressed file. In this way, requirements of applications for the length limit value are met, and a granularity of the compressed file is avoided to be excessively small.

S216: The terminal 100 performs merging and compression on first to $(N - k - 1)^{th}$ data blocks.

The length of the compressed data is greater than the length limit value, and the terminal 100 may roll back a data block, and then perform merging and compression on data blocks after rollback. The embodiment shown in FIG. 2 is described by using an example of performing merging and compression on the first to $(N - k - 1)^{th}$ data blocks after one data block is rolled back. In another possible implementation of this embodiment of this application, the terminal 100 may alternatively roll back a plurality of data blocks each time, for example, two data blocks may be rolled back.

S218: The terminal 100 continues to predict a compressed length of a data block after the $(N - k)^{th}$ data block, to continue to segment remaining data of the to-be-compressed data.

Because the first data block and the $(N - k)^{th}$ data block have been merged and compressed and the first compressed file is obtained, the terminal 100 may continue to predict a compressed length of a data block after the $(N - k)^{th}$ data block, and continue to segment remaining data of the to-be-compressed data in a same manner.

It should be noted that, according to the data compression method provided in this embodiment of this application, when a length of data obtained by compressing the to-be-compressed data is greater than the length limit value, the to-be-compressed data is segmented based on the length limit value in a process of compressing the to-be-compressed data, so that the to-be-compressed data includes at least two compressed files after compression, and a length of each compressed file is less than the length limit value. When the length of the data obtained by compressing the to-be-compressed data is less than or equal to the length limit value, the to-be-compressed data may be directly entirely compressed without performing the foregoing block division and prediction processes. It should be further noted that, when the to-be-compressed data is compressed into at least two compressed files whose lengths are less than or equal to the length limit value, the terminal 100 may further obtain a complete compressed file, and perform decompression based on the complete compressed file, to restore the to-be-compressed data.

Based on the foregoing content description, this embodiment of this application provides a data compression method. In the method, compressed lengths of data blocks are predicted, and the data blocks are merged and compressed based on prediction results, so that a length of compressed data is limited, for example, the length of the compressed data is limited within a target compression length, so that service requirements are met. In addition, according to the method, a length of the data blocks after merging and compression can be close to the target compression length, and an input of a maximum granularity is ensured, thereby ensuring a compression rate. Further, in the method, there is no need to repeatedly perform compression confirmation on same data, thereby ensuring compression performance. This method supports an automatic limitation on the compressed length, and a user does not need to conduct a test manually, thereby simplifying user operations and improving user experience.

The following describes an example in which data compression is performed according to a compression algorithm based on entropy encoding and data compression is performed according to a compression algorithm based on duplicate content search.

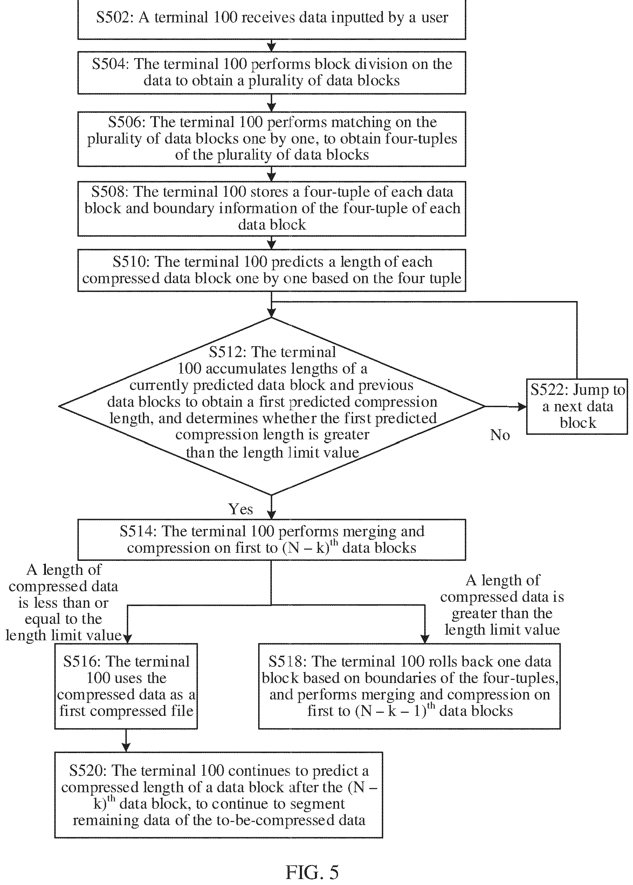

Refer to a schematic flowchart of a data compression method shown in FIG. 5, the method includes the following steps:

S502: A terminal 100 receives data inputted by a user.
S504: The terminal 100 performs block division on the data inputted by the user, to obtain a plurality of data blocks.

Specifically, the terminal 100 may perform block division on the inputted data according to an average block division method, to obtain the plurality of data blocks. Further, the terminal 100 may further determine, based on match offsets obtained by performing matching on the data blocks, quantities of intersections of boundaries of the data blocks and matches, determine an optimal position for block division based on the quantities of intersections, and merge the data blocks based on the position for block division to obtain final data blocks.

S506: The terminal 100 performs matching on the plurality of data blocks one by one according to an LZ encoding algorithm, to obtain four-tuples of the plurality of data blocks.

The four-tuple includes an unmatched character, an unmatched character length, a match length, and a match offset. The unmatched character refers to a character sequence before the matching starts, the unmatched character length refers to a length of the character sequence before the matching starts, and the match length refers to a length of a match character sequence. The match offset refers to an offset of the match character sequence relative to a matched character sequence in the unmatched character.

For ease of understanding, descriptions are made below with reference to a specific example. Assuming that a data block includes a character sequence "ASDFGSDFKHJ", the terminal 100 may determine that an unmatched character is "ASDFG", an unmatched character length is 5, and a match character sequence is "SDF". Based on this, a match length is 3. An offset from "SDF" after "ASDFG" to "SDF" in "ASDFG" is 4. Based on this, a match offset is 4. In this case, a first four-tuple may be denoted as ("ASDFG", 5, 3, 4). Then, the terminal 100 continues to perform matching on remaining characters. Specifically, matching is performed on each character from right to left. In this way, a second four-tuple ("KHJ", 3, 0, 0) may be determined.

It should be noted that, the foregoing example mainly describes an intra-block four-tuple. The terminal 100 may further perform matching across the data blocks to obtain an inter-block four-tuple. For example, when other data blocks are further included before the foregoing data block, the foregoing data block may continue to be matched with the data blocks before the foregoing data block, to obtain the inter-block four-tuple.

S508: The terminal 100 stores a four-tuple of each data block and boundary information of the four-tuple of each data block.

The terminal 100 may store the four-tuples generated in a matching process, to manage process data including the four-tuples. Further, the terminal 100 may further store the boundary information of the four-tuples, for example, a quantity of four-tuples generated when performing matching on a data block, so that the data block can be quickly rolled back based on the boundary information upon subsequent data block rollback.

S510: The terminal 100 predicts a length of each compressed data block one by one based on the four-tuple.

The terminal 100 may separately perform character frequency statistics on each element in the four-tuples of the data blocks, and obtain an occurrence probability of a character by dividing the character frequency by a total quantity of the characters. Then, the compressed length is predicted based on a Shannon-Fano entropy limit and an entropy encoding input. An entropy value prediction process mainly includes a character frequency statistics process and an entropy value calculation process, but the entropy value calculation process consumes a short time and can be ignored. In an entropy encoding process, compared with operations such as table creation and encoding that occupy more than 90% of a consumed time, character frequency statistics occupy only a short time, that is, a time for predicting the compressed length is far less than an actual compression time. Compression efficiency can be effectively improved by first predicting and then compressing.

It should be noted that, entropy encoding may be separately performed on each element by separately performing character frequency statistics on each element of the four-tuples. For an element with a small quantity of characters, an occurrence probability of the character may be effectively improved, so that an encoding effect of the corresponding element can be improved.

S512: The terminal 100 accumulates lengths of a currently predicted data block and data blocks before the currently predicted data block to obtain a first predicted compression length, and determines whether the first predicted compression length is greater than the length limit value. If the first predicted compression length is greater than the length limit value, S514 is performed. If the first predicted compression length is less than or equal to the length limit value, S522 is performed.

S514: The terminal 100 performs merging and compression on first to $(N - k)^{th}$ data blocks. When a length of compressed data is less than or equal to the length limit value, S516 is performed. When the length of the compressed data is greater than the length limit value, S518 is performed.

The terminal 100 may perform entropy encoding on the data blocks based on four-tuples of the first to $(N - k)^{th}$ data blocks, to implement merging and compression on the data blocks.

S516: The terminal 100 uses the compressed data as a first compressed file.

S518: The terminal 100 rolls back one data block based on boundaries of the four-tuples, and performs merging and compression on first to $(N - k - 1)^{th}$ data blocks.

S520: The terminal 100 continues to predict a compressed length of a data block after the $(N - k)^{th}$ data block, to continue to segment remaining data of the to-be-compressed data.

S522: The terminal 100 jumps to a next data block and then performs S512.

For specific implementations of S512 to S522, refer to the related content descriptions in the embodiment shown in FIG. 2. Details are not described herein again.

FIG. 5 describes an example in which data compression is performed according to a compression algorithm based on entropy encoding. The following describes an example in which data compression is performed according to a compression algorithm based on duplicate content search.

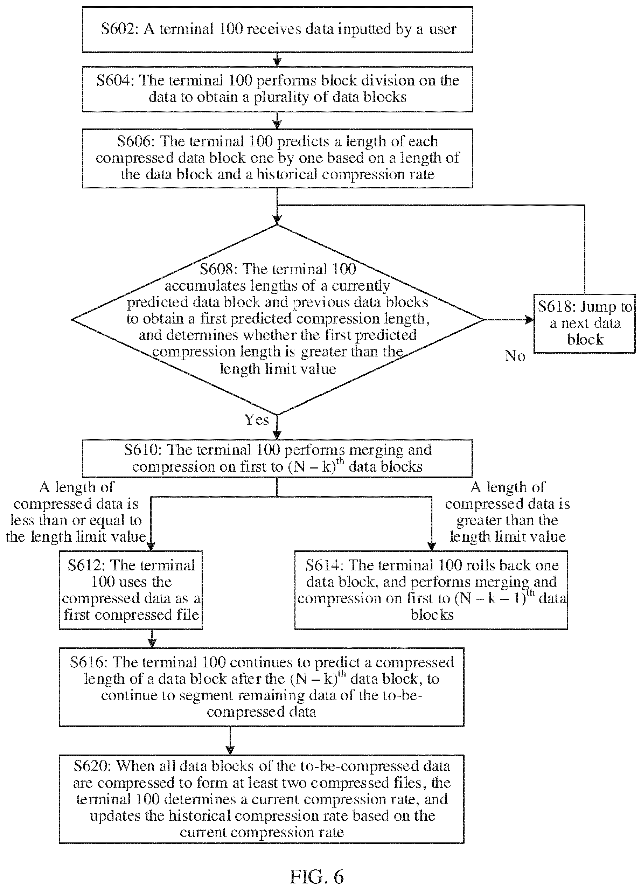

Refer to a schematic flowchart of a data compression method shown in FIG. 6, the method includes:

S602. A terminal 100 receives data inputted by a user.

S604: The terminal 100 performs block division on the data inputted by the user, to obtain a plurality of data blocks.

For specific implementations of S602 to S604, refer to the foregoing related content descriptions. Details are not described herein again.

S606: The terminal 100 predicts a length of each compressed data block one by one based on a length of the data block and a historical compression rate.

The terminal 100 maintains an overall compression rate corresponding to each compression process, and overall compression rates before current compression may be collectively referred to as a historical compression rate. The terminal 100 may predict the compressed length of the data block based on an average value of latest n compression rates and the length of the data block.

S608: The terminal 100 accumulates lengths of a currently predicted data block and data blocks before the currently predicted data block to obtain a first predicted compression length, and determines whether the first predicted compression length is greater than the length limit value. If the first predicted compression length is greater than the length limit value, S610 is performed. If the first predicted compression length is less than or equal to the length limit value, S618 is performed.

S610: The terminal 100 performs merging and compression on first to $(N - k)^{th}$ data blocks. When a length of compressed data is less than or equal to the length limit value, S612 is performed. When the length of the compressed data is greater than the length limit value, S614 is performed.

S612: The terminal 100 uses the compressed data as a first compressed file and then performs S616.

S614: The terminal 100 rolls back one data block, and performs merging and compression on first to $(N - k - 1)^{th}$ data blocks.

Specifically, the terminal 100 may perform merging and compression on the first to (N - k - 1) data blocks according to the compression algorithm based on duplicate content search.

S616: The terminal 100 continues to predict a compressed length of a data block after the $(N - k)^{th}$ data block, to continue to segment remaining data of the to-be-compressed data.

S618: The terminal 100 jumps to a next data block and then performs S608.

S620: When all data blocks of the to-be-compressed data are compressed to form at least two compressed files, the terminal 100 determines a current compression rate, and updates the historical compression rate based on the current compression rate.

Specifically, the terminal 100 may determine the current compression rate based on a length of the to-be-compressed data and a total length of the compressed files, and then maintain the current compression rate in a database or a data table, to update the historical compression rate.

The foregoing describes in detail the data compression methods provided in embodiments of this application with reference to FIG. 1 to FIG. 6. The following describes an apparatus provided in embodiments of this application with reference to the accompanying drawings.

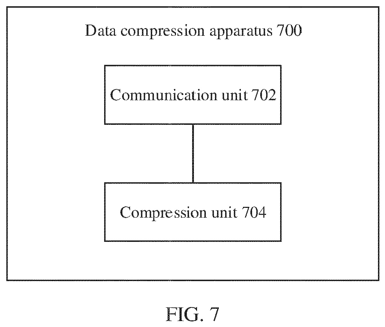

Refer to a schematic diagram of a structure of a data compression apparatus shown in FIG. 7, the data compression apparatus 700 may be a software apparatus including a software unit module with a data compression function, or the data compression apparatus 700 may be a hardware apparatus including a hardware unit module with a corresponding function. The apparatus 700 includes: a communication unit 702 and a compression unit 704.

The communication unit 702 is configured to obtain to-be-compressed data and a length limit value for data compression.

For a specific implementation in which the communication unit 702 obtains the to-be-compressed data and the length limit value for data compression, refer to the related content descriptions of S202 in the embodiment shown in FIG. 2. Details are not described herein again.

The compression unit 704 is configured to, when a length of data obtained by compressing the to-be-compressed data is greater than the length limit value, segment the to-be-compressed data based on the length limit value in a process of compressing the to-be-compressed data, so that the to-be-compressed data includes at least two compressed files after compression, and a length of each compressed file is less than the length limit value.

For a specific implementation in which the compression unit 704 segments the to-be-compressed data based on the length limit value in the process of compressing the to-be-compressed data, so that the to-be-compressed data includes at least two compressed files after compression, refer to the related content descriptions of S204 to S218 in the embodiment shown in FIG. 2. Details are not described herein again.

The compression unit 704 is specifically configured to:

predict a length of each compressed data block one by one, and accumulate lengths of a currently predicted data block and data blocks before the currently predicted block to obtain a first predicted compression length; and
when the first predicted compression length is greater than the length limit value, perform compression based on the data blocks before the currently predicted data block, where compressed data forms a first compressed file, and the first compressed file belongs to the at least two compressed files.

For a specific implementation in which the compression unit 704 predicts the compressed length of each data block one by one, and accumulates the lengths of the currently predicted data block and the data blocks before the currently predicted block to obtain the first predicted compression length, refer to the related content descriptions of S206 to S208. Details are not described herein again.

For a specific implementation in which the compression unit 704 performs compression based on the data blocks before the currently predicted data block and the compressed data forms the first compressed file, refer to the related content descriptions of S210 and S214. Details are not described herein again.

In some possible implementations, there are N data blocks before the currently predicted data block, and the compression unit 704 is specifically configured to:

perform merging and compression on first to $(N - k)^{th}$ data blocks, where N is a natural number greater than or equal to 2, and k is a natural number less than N; and

when a length of the compressed data is less than or equal to the length limit value, use the compressed data as the first compressed file.

For a specific implementation in which the compression unit 704 performs merging and compression on the first to $(N - k)^{th}$ data blocks, and when the length of the compressed data is less than or equal to the length limit value, uses the compressed data as the first compressed file, refer to the related content descriptions of S210 and S214. Details are not described herein again.

In some possible implementations, the compression unit 704 is further configured to:
continue to predict a compressed length of a data block after the $(N - k)^{th}$ data block, to continue to segment remaining data of the to-be-compressed data.

For a specific implementation in which the compression unit 704 continues to predict the compressed length of the data block after the $(N - k)^{th}$ data block, to continue to segment the remaining data of the to-be-compressed data, refer to the related content descriptions of S218. Details are not described herein again.

In some possible implementations, there are N data blocks before the currently predicted data block, and the compression unit is specifically configured to:

perform merging and compression on first to $(N - k)^{th}$ data blocks, where N is a natural number greater than or equal to 2, and k is a natural number less than N; and

when a length of the compressed data is greater than the length limit value, perform merging and compression on first to $(N - k - 1)^{th}$ data blocks.

For a specific implementation in which the compression unit 704 performs merging and compression on the first to $(N - k)^{th}$ data blocks, and when the length of the compressed data is greater than the length limit value, performs merging and compression on the first to $(N - k - 1)^{th}$ data blocks, refer to the related content descriptions of S210 and S216. Details are not described herein again.

The data compression apparatus 700 according to embodiments of this application correspondingly performs the methods described in embodiments of this application, and the foregoing and other operations and/or functions of the modules/units of the data compression apparatus 700 are separately configured to implement corresponding procedures of the methods in the embodiment shown in FIG. 2. For brevity, details are not described herein again.

An embodiment of this application further provides a device. The device is configured to implement functions of the data processing apparatus 700 in the embodiment shown in FIG. 7. The device may be a terminal such as a notebook computer or a desktop computer, or may be a local server or a cloud server. For ease of understanding, an example in which the device is a terminal is used for description.

Refer to a schematic diagram of a structure of a terminal 100 shown in FIG. 1, the terminal 100 includes a bus 101, a processor 102, a communication interface 103, and a memory 104. The processor 102, the memory 104, and the communication interface 103 communicate with each other through the bus 101.

The communication interface 103 is configured to communicate with the outside. For example, the communication interface 103 is configured to obtain to-be-compressed data, obtain a length limit value for data compression, or output at least two compressed files whose lengths are less than the length limit value, or the like. The memory 104 stores executable code, and the processor 102 executes the executable code to perform the foregoing data compression method.

An embodiment of this application further provides a computer-readable storage medium. The computer-readable storage medium includes instructions, and the instructions instruct a computer to perform the foregoing data compression methods applied to the data compression apparatus 700.

An embodiment of this application further provides a computer-readable storage medium. The computer-readable storage medium includes instructions, and the instructions instruct a computer to perform the foregoing data compression methods applied to the data compression apparatus 700.

An embodiment of this application further provides a computer program product. When the computer program product is executed by a computer, the computer performs any method of the foregoing data compression methods. The computer program product may be a software installation package. In a case that any method of the foregoing data compression methods needs to be used, the computer program product may be downloaded and the computer program product is executed by a computer.

**Claims**

1. A data compression method, wherein the method comprises:

   obtaining (S202) to-be-compressed data and a length limit value for data compression;
   performing (S204) block division on the to-be-compressed data, to obtain a plurality of initial data blocks;
   recording boundary values of the plurality of initial data blocks;
   performing matching on the plurality of initial data blocks to identify matching character sequences common amongst at least some of the initial data blocks;
   recording, based on the matching results and for each of the boundaries, quantities of intersections of the boundaries and matches, wherein a boundary and a match intersect every time a boundary character is between matching characters;
   determining an optimal position for block division based on the quantities of intersections of the boundaries and matches;
   merging the initial data blocks based on the position for block division to obtain final data blocks; and
   when a length of data obtained by compressing the to-be-compressed data is greater than the length limit value, segmenting the to-be-compressed data based on the length limit value in a process of compressing the to-be-compressed data, so that the to-be-compressed data comprises at least two compressed files after compression, and a length of each compressed file is less than the length limit value;
   wherein the segmenting the to-be-compressed data based on the length limit value comprises:

      predicting (S206) a length of each compressed final data block one by one, and accumulating (S208) a length of a currently predicted final data block and lengths of final data blocks before the currently predicted final data block to obtain a first predicted compression length; and
      when the first predicted compression length is greater than the length limit value, performing compression based on the final data blocks before the currently predicted final data block, wherein compressed data forms a first compressed file, and the first compressed file belongs to the at least two compressed files.

2. The method according to claim 1, wherein there are N data blocks before the currently predicted final data block, and the performing compression based on the final data blocks before the currently predicted final data block comprises:

   performing merging (S210) and compression on first to $(N - k)^{th}$ final data blocks, wherein N is a natural number greater than or equal to 2, and k is a natural number less than N; and
   when a length of the compressed data is less than or equal to the length limit value, using the compressed data as the first compressed file.

3. The method according to claim 2, wherein the method further comprises:
   continuing (S218) to predict a compressed length of a final data block after the $(N - k)^{th}$ final data block, to continue to segment remaining data of the to-be-compressed data.

4. The method according to claim 1, wherein there are N final data blocks before the currently predicted final data block, and the performing compression based on the final data blocks before the currently predicted final data block comprises:

   performing (S210) merging and compression on first to $(N - k)^{th}$ final data blocks, wherein N is a natural number greater than or equal to 2, and k is a natural number less than N; and
   when a length of the compressed data is greater than the length limit value, performing (S216) merging and compression on first to $(N - k - 1)^{th}$ final data blocks.

5.  A data compression apparatus (700), wherein the apparatus comprises:

    a communication unit (702), configured to obtain to-be-compressed data and a length limit value for data compression; and
    a compression unit (704), configured to:

    perform block division on the to-be-compressed data, to obtain a plurality of initial data blocks;
    record boundary values of the plurality of initial data blocks;
    perform matching on the plurality of initial data blocks to identify matching character sequences common amongst at least some of the initial data blocks;
    record, based on the matching results and for each of the boundaries, quantities of intersections of the boundaries and matches, wherein a boundary and a match intersect every time a boundary character is between matching characters;
    determine an optimal position for block division based on the quantities of intersections of the boundaries and matches; and
    merge the initial data blocks based on the position for block division to obtain final data blocks;
    wherein the compression unit is further configured to, when a length of data obtained by compressing the to-be-compressed data is greater than the length limit value, segment the to-be-compressed data based on the length limit value in a process of compressing the to-be-compressed data, so that the to-be-compressed data comprises at least two compressed files after compression, and a length of each compressed file is less than the length limit value;
    and wherein the compression unit is specifically configured to:

    predict a length of each compressed data block one by one, and accumulate a length of a currently predicted data block and lengths of data blocks before the currently predicted data block to obtain a first predicted compression length; and
    when the first predicted compression length is greater than the length limit value, perform compression based on the data blocks before the currently predicted data block, wherein compressed data forms a first compressed file, and the first compressed file belongs to the at least two compressed files.

6.  The apparatus (700) according to claim 5, wherein there are N final data blocks before the currently predicted final data block, and the compression unit (704) is specifically configured to:

    perform merging and compression on first to $(N - k)^{th}$ final data blocks, wherein N is a natural number greater than or equal to 2, and k is a natural number less than N; and
    when a length of the compressed data is less than or equal to the length limit value, use the compressed data as the first compressed file.

7.  The apparatus (700) according to claim 6, wherein the compression unit (704) is further configured to:
    continue to predict a compressed length of a final data block after the $(N - k)^{th}$ final data block, to continue to segment remaining data of the to-be-compressed data.

8.  The apparatus (700) according to claim 5, wherein there are N final data blocks before the currently predicted final data block, and the compression unit (704) is specifically configured to:

    perform merging and compression on first to $(N - k)^{th}$ final data blocks, where N is a natural number greater than or equal to 2, and k is a natural number less than N; and
    when a length of the compressed data is greater than the length limit value, perform merging and compression on first to $(N - k - 1)^{th}$ final data blocks.

9.  A computer-readable storage medium (104), comprising: computer-readable instructions, wherein when the computer-readable instructions are run on a computer (100), the computer performs the method according to any one of claims 1 to 4.

10. A computer program product, comprising: computer-readable instructions, wherein when the computer-readable instructions are run on a computer (100), the computer performs the method according to any one of claims 1 to 4.

**Patentansprüche**

1. Datenkomprimierungsverfahren, wobei das Verfahren umfasst:

   Erhalten (S202) zu komprimierender Daten und eines Längengrenzwerts für eine Datenkomprimierung;
   Durchführen (S204) einer Blockaufteilung an den zu komprimierenden Daten, um eine Vielzahl von anfänglichen Datenblöcken zu erhalten;
   Aufzeichnen von Randwerten der Vielzahl von anfänglichen Datenblöcken;
   Durchführen eines Abstimmens an der Vielzahl von anfänglichen Datenblöcken, um abgestimmte Zeichenfolgen, die mindestens einigen der anfänglichen Datenblöcke gemeinsam sind, zu identifizieren;
   Aufzeichnen, basierend auf den Abstimmungsergebnissen und für jeden der Ränder,
   einer Anzahl von Schnittpunkten der Ränder und Abstimmungen, wobei sich ein Rand und eine Abstimmung jedes Mal, wenn sich ein Randzeichen zwischen abgestimmten Zeichen befindet, überschneiden;
   Bestimmen einer optimalen Position für die Blockaufteilung basierend auf der Anzahl von Schnittpunkten der Ränder und Abstimmungen;
   Zusammenführen der anfänglichen Datenblöcke basierend auf der Position für die Blockaufteilung, um endgültige Datenblöcke zu erhalten; und
   wenn eine Länge von Daten, die durch ein Komprimieren der zu komprimierenden Daten erhalten werden, größer als der Längengrenzwert ist, Segmentieren der zu komprimierenden Daten basierend auf dem Längengrenzwert in einem Prozess zum Komprimieren der zu komprimierenden Daten, sodass die zu komprimierenden Daten mindestens zwei komprimierte Dateien nach einer Komprimierung umfassen und eine Länge jeder komprimierten Datei geringer als der Längengrenzwert ist;
   wobei das Segmentieren der zu komprimierenden Daten basierend auf dem Längengrenzwert umfasst:

   Vorhersagen (S206) einer Länge jedes komprimierten endgültigen Datenblocks nacheinander und Akkumulieren (S208) einer Länge eines aktuell vorhergesagten endgültigen Datenblocks und Längen von endgültigen Datenblöcken vor dem aktuell vorhergesagten endgültigen Datenblock, um eine erste vorhergesagte Komprimierungslänge zu erhalten; und
   wenn die erste vorhergesagte Komprimierungslänge größer als der Längengrenzwert ist, Durchführen der Komprimierung basierend auf den endgültigen Datenblöcken vor dem aktuell vorhergesagten endgültigen Datenblock, wobei komprimierte Daten eine erste komprimierte Datei ausbilden und die erste komprimierte Datei zu den mindestens zwei komprimierten Dateien gehört.

2. Verfahren nach Anspruch 1, wobei N Datenblöcke vor dem aktuell vorhergesagten endgültigen Datenblock vorhanden sind und das Durchführen der Komprimierung basierend auf den endgültigen Datenblöcken vor dem aktuell vorhergesagten endgültigen Datenblock umfasst:

   Durchführen des Zusammenführens (S210) und der Komprimierung an ersten bis (N - k)-ten endgültigen Datenblöcken, wobei N eine natürliche Zahl größer als oder gleich 2 ist und k eine natürliche Zahl geringer als N ist; und
   wenn eine Länge der komprimierten Daten geringer als oder gleich dem Längengrenzwert ist, Verwenden der komprimierten Daten als die erste komprimierte Datei.

3. Verfahren nach Anspruch 2, wobei das Verfahren ferner umfasst:
   Fortfahren (S218), um eine komprimierte Länge eines endgültigen Datenblocks nach dem (N - k)-ten endgültigen Datenblock vorherzusagen, um fortzufahren, um verbleibende Daten der zu komprimierenden Daten zu segmentieren.

4. Verfahren nach Anspruch 1, wobei N endgültige Datenblöcke vor dem aktuell vorhergesagten endgültigen Datenblock vorhanden sind und das Durchführen der Komprimierung basierend auf den endgültigen Datenblöcken vor dem aktuell vorhergesagten endgültigen Datenblock umfasst:

   Durchführen (S210) des Zusammenführens und der Komprimierung an ersten bis (N - k)-ten endgültigen Datenblöcken, wobei N eine natürliche Zahl größer als oder gleich 2 ist und k eine natürliche Zahl geringer als N ist; und
   wenn eine Länge der komprimierten Daten größer als der Längengrenzwert ist, Durchführen (S216) des Zusammenführens und der Komprimierung an ersten bis (N - k - 1)-ten endgültigen Datenblöcken.

5. Datenkomprimierungseinrichtung (700), wobei die Einrichtung umfasst:

> eine Kommunikationseinheit (702), die konfiguriert ist, um zu komprimierende Daten und einen Längengrenzwert für die Datenkomprimierung zu erhalten; und
> eine Komprimierungseinheit (704), die konfiguriert ist zum:
>
> > Durchführen der Blockaufteilung an den zu komprimierenden Daten, um eine Vielzahl von anfänglichen Datenblöcken zu erhalten;
> > Aufzeichnen von Randwerten der Vielzahl von anfänglichen Datenblöcken;
> > Durchführen des Abstimmens an der Vielzahl von anfänglichen Datenblöcken, um abgestimmte Zeichenfolgen, die mindestens einigen der anfänglichen Datenblöcke gemeinsam sind, zu identifizieren;
> > Aufzeichnen, basierend auf den Abstimmungsergebnissen und für jeden der Ränder, einer Anzahl von Schnittpunkten der Ränder und Abstimmungen, wobei sich ein Rand und eine Abstimmung jedes Mal, wenn sich ein Randzeichen zwischen abgestimmten Zeichen befindet, überschneiden;
> > Bestimmen einer optimalen Position für die Blockaufteilung basierend auf der Anzahl von Schnittpunkten der Ränder und Abstimmungen; und
> > Zusammenführen der anfänglichen Datenblöcke basierend auf der Position für die Blockaufteilung, um endgültige Datenblöcke zu erhalten;
> > wobei die Komprimierungseinheit ferner konfiguriert ist, wenn eine Länge von Daten, die durch das Komprimieren der zu komprimierenden Daten erhalten werden, größer als der Längengrenzwert ist, die zu komprimierenden Daten basierend auf dem Längengrenzwert in einem Prozess zum Komprimieren der zu komprimierenden Daten zu segmentieren, sodass die zu komprimierenden Daten mindestens zwei komprimierte Dateien nach der Komprimierung umfassen und eine Länge jeder komprimierten Datei geringer als der Längengrenzwert ist;
> > und wobei die Komprimierungseinheit speziell konfiguriert ist zum:
> >
> > > Vorhersagen einer Länge jedes komprimierten Datenblocks nacheinander und Akkumulieren einer Länge eines aktuell vorhergesagten Datenblocks und Längen von Datenblöcken vor dem aktuell vorhergesagten Datenblock, um eine erste vorhergesagte Komprimierungslänge zu erhalten; und
> > > wenn die erste vorhergesagte Komprimierungslänge größer als der Längengrenzwert ist, Durchführen der Komprimierung basierend auf den Datenblöcken vor dem aktuell vorhergesagten Datenblock, wobei komprimierte Daten eine erste komprimierte Datei ausbilden und die erste komprimierte Datei zu den mindestens zwei komprimierten Dateien gehört.

6. Einrichtung (700) nach Anspruch 5, wobei N endgültige Datenblöcke vor dem aktuell vorhergesagten endgültigen Datenblock vorhanden sind und die Komprimierungseinheit (704) speziell konfiguriert ist zum:

> Durchführen des Zusammenführens und der Komprimierung an ersten bis (N - k)-ten endgültigen Datenblöcken, wobei N eine natürliche Zahl größer als oder gleich 2 ist und k eine natürliche Zahl geringer als N ist; und
> wenn eine Länge der komprimierten Daten geringer als oder gleich dem Längengrenzwert ist, Verwenden der komprimierten Daten als die erste komprimierte Datei.

7. Einrichtung (700) nach Anspruch 6, wobei die Komprimierungseinheit (704) ferner konfiguriert ist zum:
Fortfahren, um eine komprimierte Länge eines endgültigen Datenblocks nach dem (N - k)-ten endgültigen Datenblock vorherzusagen, um fortzufahren, um verbleibende Daten der zu komprimierenden Daten zu segmentieren.

8. Einrichtung (700) nach Anspruch 5, wobei N endgültige Datenblöcke vor dem aktuell vorhergesagten endgültigen Datenblock vorhanden sind und die Komprimierungseinheit (704) speziell konfiguriert ist zum:

> Durchführen des Zusammenführens und der Komprimierung an ersten bis (N - k)-ten endgültigen Datenblöcken, wobei N eine natürliche Zahl größer als oder gleich 2 ist und k eine natürliche Zahl geringer als N ist; und
> wenn eine Länge der komprimierten Daten größer als der Längengrenzwert ist, Durchführen des Zusammenführens und der Komprimierung an ersten bis (N - k - 1)-ten endgültigen Datenblöcken.

9. Computerlesbares Speichermedium (104), das umfasst: computerlesbare Anweisungen, wobei, wenn die computerlesbaren Anweisungen auf einem Computer (100) ablaufen, der Computer das Verfahren nach einem der Ansprüche 1 bis 4 durchführt.

**10.** Computerprogrammprodukt, das umfasst: computerlesbare Anweisungen, wobei, wenn die computerlesbaren Anweisungen auf einem Computer (100) ablaufen, der Computer das Verfahren nach einem der Ansprüche 1 bis 4 durchführt.

**Revendications**

**1.** Procédé de compression de données, dans lequel le procédé comprend :

l'obtention (S202) de données à compresser et une valeur limite de longueur pour une compression de données ;
la réalisation (S204) d'une division de blocs sur les données à compresser, pour obtenir une pluralité de blocs de données initiaux ;
l'enregistrement de valeurs de frontière de la pluralité de blocs de données initiaux ;
la réalisation de la mise en correspondance sur la pluralité de blocs de données initiaux pour identifier des séquences de caractères correspondantes communes parmi au moins certains des blocs de données initiaux ;
l'enregistrement, sur la base des résultats de correspondance et pour chacune des frontières, de quantités d'intersections des frontières et des correspondances, dans lequel une frontière et une correspondance se croisent chaque fois qu'un caractère de frontière se trouve entre des caractères correspondants ;
la détermination d'une position optimale pour la division de blocs sur la base des quantités d'intersections des frontières et des correspondances ;
la fusion des blocs de données initiaux sur la base de la position de division de blocs pour obtenir des blocs de données finaux ; et
lorsqu'une longueur de données obtenue par compression des données à compresser est supérieure à la valeur limite de longueur, la segmentation des données à compresser sur la base de la valeur limite de longueur dans un processus de compression des données à compresser, de sorte que les données à compresser comprennent au moins deux fichiers compressés après compression, et qu'une longueur de chaque fichier compressé est inférieure à la valeur limite de longueur ;
dans lequel la segmentation des données à compresser sur la base de la valeur limite de longueur comprend :

la prédiction (S206) d'une longueur de chaque bloc de données final compressé, un par un, et l'accumulation (S208) d'une longueur d'un bloc de données final actuellement prédit et des longueurs de blocs de données finaux avant le bloc de données final actuellement prédit pour obtenir une première longueur de compression prédite ; et
lorsque la première longueur de compression prédite est supérieure à la valeur limite de longueur, la réalisation de la compression sur la base des blocs de données finaux avant le bloc de données final actuellement prédit, dans lequel les données compressées forment un premier fichier compressé, et le premier fichier compressé appartient aux au moins deux fichiers compressés.

**2.** Procédé selon la revendication 1, dans lequel il y a N blocs de données avant le bloc de données final actuellement prédit, et la réalisation de la compression sur la base des blocs de données finaux avant le bloc de données final actuellement prédit comprend :

la réalisation de la fusion (S210) et de la compression sur le premier aux $(N - k)^{ièmes}$ blocs de données finaux, dans lequel N est un nombre naturel supérieur ou égal à 2, et k est un nombre naturel inférieur à N ; et
lorsqu'une longueur des données compressées est inférieure ou égale à la valeur limite de longueur, l'utilisation des données compressées comme premier fichier compressé.

**3.** Procédé selon la revendication 2, dans lequel le procédé comprend en outre :
la poursuite (S218) de la prédiction d'une longueur compressée d'un bloc de données final après le $(N - k)^{ième}$ bloc de données final, pour continuer à segmenter des données restantes des données à compresser.

**4.** Procédé selon la revendication 1, dans lequel il y a N blocs de données finaux avant le bloc de données final actuellement prédit, et la réalisation de la compression sur la base des blocs de données finaux avant le bloc de données final actuellement prédit comprend :

la réalisation (S210) de la fusion et de la compression sur le premier aux $(N - k)^{ièmes}$ blocs de données finaux, dans lequel N est un nombre naturel supérieur ou égal à 2, et k est un nombre naturel inférieur à N ; et
lorsqu'une longueur des données compressées est supérieure à la valeur limite de longueur, la réalisation (S216) de la fusion et de la compression sur le premier aux (N - k - 1)$^{\text{ièmes}}$ blocs de données finaux.

5. Appareil de compression de données (700), dans lequel l'appareil comprend :

une unité de communication (702), configurée pour obtenir des données à compresser et une valeur limite de longueur pour la compression de données ; et
une unité de compression (704), configurée pour :

réaliser une division de bloc sur les données à compresser, afin d'obtenir une pluralité de blocs de données initiaux ;
enregistrer des valeurs de frontière de la pluralité de blocs de données initiaux ;
réaliser une mise en correspondance sur la pluralité de blocs de données initiaux afin d'identifier des séquences de caractères correspondantes communes parmi au moins certains des blocs de données initiaux ;
enregistrer, sur la base des résultats de correspondance et pour chacune des frontières, des quantités d'intersections des frontières et des correspondances, dans lequel une frontière et une correspondance se croisent chaque fois qu'un caractère de frontière se trouve entre des caractères correspondants ;
déterminer une position optimale pour la division de blocs sur la base des quantités d'intersections des frontières et des correspondances ; et
fusionner les blocs de données initiaux sur la base de la position de division de blocs afin d'obtenir des blocs de données finaux ;
dans lequel l'unité de compression est en outre configurée pour, lorsqu'une longueur de données obtenue par compression des données à compresser est supérieure à la valeur limite de longueur, segmenter les données à compresser sur la base de la valeur limite de longueur dans un processus de compression des données à compresser, de sorte que les données à compresser comprennent au moins deux fichiers compressés après compression, et qu'une longueur de chaque fichier compressé est inférieure à la valeur limite de longueur ;
et dans lequel l'unité de compression est spécifiquement configurée pour :

prédire une longueur de chaque bloc de données compressé, un par un, et accumuler une longueur d'un bloc de données actuellement prédit et des longueurs de blocs de données avant le bloc de données actuellement prédit, afin d'obtenir une première longueur de compression prédite ; et
lorsque la première longueur de compression prédite est supérieure à la valeur limite de longueur, réaliser la compression sur la base des blocs de données avant le bloc de données actuellement prédit, dans lequel des données compressées forment un premier fichier compressé, et le premier fichier compressé appartient aux au moins deux fichiers compressés.

6. Appareil (700) selon la revendication 5, dans lequel il y a N blocs de données finaux avant le bloc de données final actuellement prédit, et l'unité de compression (704) est spécifiquement configurée pour :

réaliser la fusion et la compression sur le premier aux (N - k)$^{\text{ièmes}}$ blocs de données finaux, dans lequel N est un nombre naturel supérieur ou égal à 2, et k est un nombre naturel inférieur à N ; et
lorsqu'une longueur des données compressées est inférieure ou égale à la valeur limite de longueur, utiliser les données compressées comme premier fichier compressé.

7. Appareil (700) selon la revendication 6, dans lequel l'unité de compression (704) est en outre configurée pour :
continuer à prédire une longueur compressée d'un bloc de données final après le (N - k)$^{\text{ième}}$ bloc de données final, afin de continuer à segmenter des données restantes des données à compresser.

8. Appareil (700) selon la revendication 5, dans lequel il y a N blocs de données finaux avant le bloc de données final actuellement prédit, et l'unité de compression (704) est spécifiquement configurée pour :

réaliser la fusion et la compression sur le premier aux (N - k)$^{\text{ièmes}}$ blocs de données finaux, où N est un nombre naturel supérieur ou égal à 2, et k est un nombre naturel inférieur à N ; et
lorsqu'une longueur des données compressées est supérieure à la valeur limite de longueur, réaliser la fusion et la compression sur le premier aux (N - k - 1)$^{\text{ièmes}}$ blocs de données finaux.

9. Support de stockage lisible par ordinateur (104), comprenant : des instructions lisibles par ordinateur, dans lequel, lorsque les instructions lisibles par ordinateur sont exécutées sur un ordinateur (100), l'ordinateur réalise le procédé selon l'une quelconque des revendications 1 à 4.

10. Produit-programme informatique, comprenant des instructions lisibles par ordinateur, dans lequel, lorsque les instructions lisibles par ordinateur sont exécutées sur un ordinateur (100), l'ordinateur réalise le procédé selon l'une quelconque des revendications 1 à 4.

FIG. 1

A terminal 100 obtains to-be-compressed data and a length limit value for data compression — S202

The terminal 100 obtains a plurality of data blocks based on the to-be-compressed data — S204

The terminal 100 predicts a length of each compressed data block one by one — S206

The terminal 100 accumulates lengths of a currently predicted data block and previous data blocks to obtain a first predicted compression length, and determines whether the first predicted compression length is greater than the length limit value

No → Jump to a next data block — S212

S208

Yes

The terminal 100 performs merging and compression on first to $(N - k)^{th}$ data blocks — S210

A length of compressed data is less than or equal to the length limit value

A length of compressed data is greater than the length limit value

The terminal 100 uses the compressed data as a first compressed file — S214

The terminal 100 performs merging and compression on first to $(N - k - 1)^{th}$ data blocks — S216

The terminal 100 continues to predict a compressed length of a data block after the $(N - k)^{th}$ data block, to continue to segment remaining data of the to-be-compressed data — S218

FIG. 2

Data compression

Data address | ftp://xx.yy.com ▽ | Browse ⌇302

Length
limit value | 20 MB ▽ ⌇304

Submit ⌇306    Cancel ⌇308

FIG. 3

Data stream

Initial data blocks

Schematic diagram of
field matching of the
initial data blocks

Adjusted data blocks

FIG. 4

S502: A terminal 100 receives data inputted by a user

S504: The terminal 100 performs block division on the data to obtain a plurality of data blocks

S506: The terminal 100 performs matching on the plurality of data blocks one by one, to obtain four-tuples of the plurality of data blocks

S508: The terminal 100 stores a four-tuple of each data block and boundary information of the four-tuple of each data block

S510: The terminal 100 predicts a length of each compressed data block one by one based on the four tuple

S512: The terminal 100 accumulates lengths of a currently predicted data block and previous data blocks to obtain a first predicted compression length, and determines whether the first predicted compression length is greater than the length limit value

S522: Jump to a next data block

No

Yes

S514: The terminal 100 performs merging and compression on first to $(N - k)^{th}$ data blocks

A length of compressed data is less than or equal to the length limit value

A length of compressed data is greater than the length limit value

S516: The terminal 100 uses the compressed data as a first compressed file

S518: The terminal 100 rolls back one data block based on boundaries of the four-tuples, and performs merging and compression on first to $(N - k - 1)^{th}$ data blocks

S520: The terminal 100 continues to predict a compressed length of a data block after the $(N - k)^{th}$ data block, to continue to segment remaining data of the to-be-compressed data

FIG. 5

S602: A terminal 100 receives data inputted by a user

S604: The terminal 100 performs block division on the data to obtain a plurality of data blocks

S606: The terminal 100 predicts a length of each compressed data block one by one based on a length of the data block and a historical compression rate

S608: The terminal 100 accumulates lengths of a currently predicted data block and previous data blocks to obtain a first predicted compression length, and determines whether the first predicted compression length is greater than the length limit value

S618: Jump to a next data block

No

Yes

S610: The terminal 100 performs merging and compression on first to $(N - k)^{th}$ data blocks

A length of compressed data is less than or equal to the length limit value

A length of compressed data is greater than the length limit value

S612: The terminal 100 uses the compressed data as a first compressed file

S614: The terminal 100 rolls back one data block, and performs merging and compression on first to $(N - k - 1)^{th}$ data blocks

S616: The terminal 100 continues to predict a compressed length of a data block after the $(N - k)^{th}$ data block, to continue to segment remaining data of the to-be-compressed data

S620: When all data blocks of the to-be-compressed data are compressed to form at least two compressed files, the terminal 100 determines a current compression rate, and updates the historical compression rate based on the current compression rate

FIG. 6

Data compression apparatus 700

Communication unit 702

Compression unit 704

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110343760
- EP 3820048 A1
- US 10310737 B1
- WO 2020025006 A1